# EUROPEAN PATENT SPECIFICATION

(11) **EP 4 191 254 B1**
(45) Date of publication and mention of the grant of the patent: **18.11.2026**
(21) Application number: 22763138.9
(22) Date of filing: 25.02.2022
(51) Int. Cl.: G01R 15/18, H01F 5/06, H01F 38/28, H01F 38/30

(54) **CURRENT SENSOR AND MANUFACTURING METHOD OF CURRENT SENSOR**
STROMSENSOR UND HERSTELLUNGSVERFAHREN FÜR DEN STROMSENSOR
CAPTEUR DE COURANT ET PROCÉDÉ DE FABRICATION D'UN CAPTEUR DE COURANT

(30) Priority: 05.03.2021 JP 2021035439
(43) Date of publication of application: 07.06.2023
(73) Proprietor: FUJI ELECTRIC FA COMPONENTS & SYSTEMS CO., LTD., Konosu-shi, Saitama 369-0192 (JP)
(72) Inventor: KATO, Yoshihiko, Konosu-shi, Saitama 369-0192 (JP); HIROSE, Takamine, Konosu-shi, Saitama 369-0192 (JP); HAYAKAWA, Kensuke, Konosu-shi, Saitama 369-0192 (JP)
(74) Representative: Appelt, Christian W.
(86) International application number: PCT/JP2022/007968
(87) International publication number: WO 2022/186082

(56) References cited:
- WO-A1-2019/087572
- WO-A1-2020/008544
- JP-A- 2001 343 401
- JP-A- 2011 521 252
- JP-A- 2012 088 224
- JP-A- 2018 105 678
- JP-A- 2018 105 678
- JP-A- 2019 020 369
- JP-A- 2019 027 970
- JP-U- S5 130 575
- JP-U- S5 130 575
- US-A1- 2013 008 179
- US-A1- 2018 017 600
- MURGATROYD P N ET AL: "Making Rogowski coils", MEASUREMENT SCIENCE AND TECHNOLOGY, IOP, BRISTOL, GB, vol. 2, no. 12, 1 December 1991 (1991-12-01), pages 1218 - 1219, XP020065161, ISSN: 0957-0233, DOI: 10.1088/0957-0233/2/12/021

## Description

### TECHNICAL FIELD

The present invention relates to a current sensor and a manufacturing method of current sensor.

### BACKGROUND ART

Rogowski coils, which are configured by winding a coil winding around an annular insulator core, are known as current sensors that can measure the current of a measurement conductor in a wide range (for example, JP 2019-27970 A).

When current flows through a measurement conductor inserted into a center space of the insulator core in a Rogowski coil, an induction voltage (output voltage) corresponding to the current of the measurement conductor is output from an output terminal of the coil winding. The output voltage is used to calculate a current value flowing through the measurement conductor.

MURGATROYD P N ET AL: "Making Rogowski coils", MEASUREMENT SCIENCE AND TECHNOLOGY, IOP, BRISTOL, GB, vol. 2, no. 12,1 December 1991 (1991-12-01), pages 1218-1219, XP020065161, describes fabrication methods for Rogowski coils.

JP 2018-105678 A describes a current sensor, which comprises: a winding core having a first end and a second end; a coil formed on an outer peripheral surface of the winding core from the first end to the second end; and a rewinding wire which is disposed inside the winding core and penetrates through the winding core from the first end to the second end and of which an end at a side of the first end is connected to an end of the coil at a side of the first end.

### SUMMARY OF INVENTION

### Technical Problem

In order to perform coil winding on an annular insulator core in a process for manufacturing a Rogowski coil, it is necessary to store wire in a winding mechanism called a wire storage ring. The size of the wire storage ring, which depends on the size of an inner circumference of the annular insulator core, has a limit with respect to the amount of the wire stored. Since Rogowski coils are current sensors in which output voltage is increased by reducing a magnetic path length of the annular insulator core (reducing the inner circumference of the insulator core) or increasing the number of windings (increasing the amount of wire stored, a limit exists to how large the output can be. Thus, Rogowski coils are not suitable for measuring currents of thin measurement conductors where low currents flow.

Since Rogowski coils are limited with respect to the amount of coil windings to be wound on the insulator core, it is difficult to obtain a high-sensitivity current sensor for low current measurements that require high output voltages.

However, since Rogowski coils include no magnetic core, they are current sensors that are not affected by magnetic saturation of the core and suitable for large current measurements. CTs, which are common current sensors, use a core containing magnetic material to obtain an output voltage at low current, and are used for low current measurements. However, at large currents where the core saturates, linearity of an output ratio between output voltage and measured current is lost, so that CTs are not suitable for large currents. Additionally, measuring large current causes a problem of increased size to prevent the magnetic saturation of the core.

Furthermore, manufacturing a Rogowski coil requires dedicated equipment having a wire storage ring for winding coil windings around the annular insulator core. This is problematic in terms of manufacturing cost.

Accordingly, the present invention has been made in view of the conventional problems. It is an object of the present invention to provide a wide-range current sensor capable of measuring the current of a measurement conductor with high output voltage and high sensitivity and a method for manufacturing a current sensor capable of reducing manufacturing cost.

### Solution to Problem

In order to achieve the above-described object, the present invention relates to a current sensor according to claim 1, a current sensor according to claim 5, a method according to claim 6, and a method according to claim 7.

According to an aspect of the present invention, there is provided a current sensor wound and mounted in a spiral shape with at least one winding around a measurement conductor where a primary current flows, the current sensor including: an insulated electrical wire including a core wire having a flexible rod-shaped body and an insulating covering portion covering an outer periphery of the core wire; and a coil thin wire having one end electrically connected to one end side of the core wire, and functioning as a secondary coil by being wound around an outer periphery of the insulating covering portion, wherein an other end of the core wire and an other end of the coil thin wire, which are not electrically connected, are used as output terminals.

According to another aspect of the present invention, there is provided a method for manufacturing a current sensor, which is a method for manufacturing the current sensor described above, the method including: electrically connecting one end of the coil thin wire to one end side of the core wire of the insulated electrical wire; winding the coil thin wire around an outer periphery of the insulating covering portion of the insulated electrical wire from the one end side to arrange as a secondary coil; using an other end of the core wire and an other end of the coil thin wire, which are not electrically connected, as output terminals; and winding the insulated electrical wire wound with the coil thin wire around a measurement conductor where a primary current flows, in a spiral shape with at least one winding.

### Advantageous Effects of Invention

The current sensor according to the present invention enables wide-range current measurement in which the current of a measurement conductor can be measured with high output voltage and high sensitivity. In addition, the method for manufacturing a current sensor according to the present invention enables reduced manufacturing cost.

### BRIEF DESCRIPTION OF DRAWINGS

Each of the following figures does not necessarily show each aspect of the present invention, which is defined by the independent claims. In particular, each of the following current sensors is only part of the present invention if it includes the first-layer winding, the second-layer winding, and the third-layer winding as defined by claims 1 and 5.
FIG. 1 is a diagram illustrating a current measurement device of a first embodiment according to the present invention;
FIGS. 2A to 2C are diagrams illustrating a process for manufacturing a current sensor with a single-layer winding for use in the first embodiment;
FIG. 3 is a diagram illustrating the structure of the current sensor with a double-layer winding for use in the first embodiment;
FIGS. 4A and 4B are diagrams illustrating the structure of the current sensor with a triple-layer winding for use in the first embodiment;
FIG. 5 is a diagram illustrating a state in which the current sensor for use in the first embodiment is wound around a measurement conductor having a large diameter;
FIG. 6 is a cross-sectional diagram illustrating the structure of a current sensor of a second embodiment according to the present invention;
FIG. 7 is a cross-sectional diagram illustrating the structure of a current sensor of a third embodiment according to the present invention;
FIG. 8 is a cross-sectional diagram illustrating the structure of a current sensor of a fourth embodiment according to the present invention;
FIG. 9 is a cross-sectional diagram illustrating the structure of a current sensor of a fifth embodiment according to the present invention;
FIG. 10 is a graph illustrating a relationship between current flowing through the measurement conductor and output voltage RMS values of the current sensors of the first to third embodiments;
FIG. 11 is a graph in which the scale of the output voltages of the graph in FIG. 10 is changed;
FIG. 12 is a graph in which the scale of the output voltages of the graph in FIG. 10 is further changed; and
FIG. 13 is a diagram illustrating output voltage waveforms of the current sensors of the first to third embodiments.

### DESCRIPTION OF EMBODIMENTS

Next, with reference to the accompanying drawings, an embodiment according to the present invention will be described. In the following description of the drawings, the same or similar reference signs are assigned to the same or similar composing elements. However, it should be noted that the drawings are schematic and relations between thicknesses and planar dimensions, ratios among thicknesses of respective layers, and the like are different from actual ones. Therefore, specific thicknesses and dimensions should be determined in consideration of the following description. It should also be noted that the drawings include portions having different dimensional relationships and ratios from each other.

In addition, the embodiment, which will be described below, indicate devices and methods to embody the technical idea of the present invention, and the technical idea of the present invention does not limit the materials, shapes, structures, arrangements, and the like of the constituent components to those described below. The technical idea of the present invention can be subjected to a variety of alterations within the technical scope prescribed by the claims.

### First Embodiment

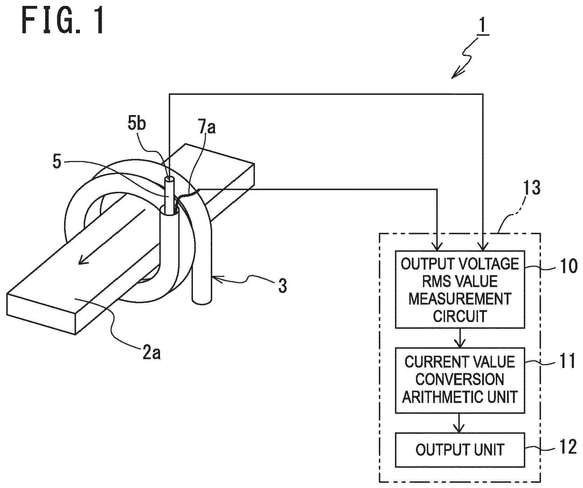

FIG. 1 illustrates a current measurement device 1 of a first embodiment according to the present invention. The current measurement device 1 includes a current sensor 3 wound around and mounted onto a measurement conductor 2a where a primary current flows and a measured current display device 13 that is connected to the current sensor 3, and is a device for measuring a low measured current (alternating current) flowing through the measurement conductor 2a.

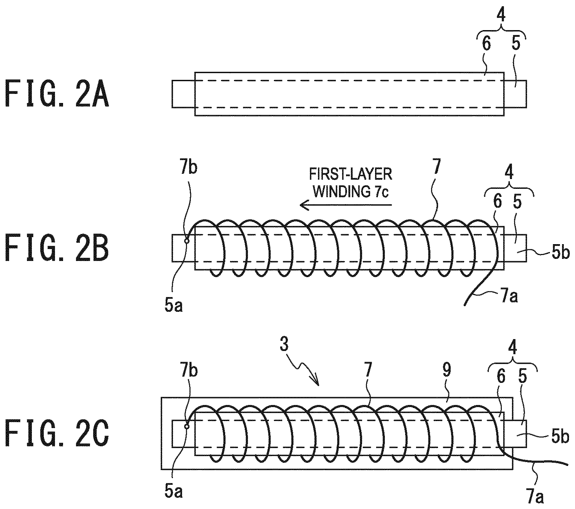

FIG. 2C illustrates the current sensor 3 with a single-layer winding. The current sensor 3 includes an insulated electrical wire 4 having a flexible rod-shaped body (for example, an cylindrical body having a substantially constant diameter), a core wire 5 forming the insulated electrical wire 4, an insulating covering portion 6 covering an outer periphery of the core wire 5 and forming the insulated electrical wire 4, a coil thin wire 7 made of a copper wire, which functions as a secondary coil by winding a first-layer winding 7c around an outer periphery of the insulating covering portion 6, and a heat shrinkable tube 9 that is used as a protective covering for the core wire 5 and the coil thin wire 7.

The core wire 5 of the insulated electrical wire 4 has a rod-shaped body made of copper or aluminum, which is a non-magnetic material. The insulating covering portion 6 is formed by using an insulating resin tube or applying an insulating resin onto the core wire 5.

A winding end portion 7b of the coil thin wire 7 wound around the insulating covering portion 6 is connected to an electrical connection portion 5a at one end of the core wire 5, and an end portion 5b at an other end side of the core wire 5 and a free end portion 7a of the coil thin wire 7 function as a pair of output terminals (hereinafter referred to as output terminals 5b and 7a) of the current sensor 3.

Then, as illustrated in FIG. 1, the current sensor 3 is mounted around the measurement conductor 2a by spirally winding the current sensor 3 so as to surround the measurement conductor 2a having a rectangular shape.

The measured current display device 13 includes an output voltage RMS value measurement circuit 10 to which the output terminals 5b and 7a of the current sensor 3 is connected, a current value conversion arithmetic unit 11, and an output unit 12.

The output voltage RMS value measurement circuit 10 is a circuit that outputs a voltage waveform output from the current sensor 3 as an RMS value of the voltage.

The current value conversion arithmetic unit 11 is a circuit that converts the voltage RMS value output from the output voltage RMS value measurement circuit 10 to a measured current value by using a calculation formula.

The output unit 12 is formed by, for example, a display device such as an LCD, and displays the current value output from the current value conversion arithmetic unit 11 on the screen.

A process for manufacturing the current sensor 3 of the first embodiment is described with reference to FIGS. 2A to 2C.

As illustrated in FIG. 2A, with the insulated electrical wire 4 in a straight line, the coil thin wire 7 is wound around the outer periphery of the insulating covering portion 6 of the insulated electrical wire 4 as the first-layer winding wire 7c, and the winding end portion 7b is connected to the electrical connection portion 5a of the core wire 5, as illustrated in FIG. 2B. In this case, a common spindle-type winding machine is used. Thus, a wire is supplied from a wire bobbin, and winding can be performed regardless of the amount of wire stored. Therefore, layer winding can also be performed. It is desirable to perform winding in an odd number of layers, whereby the core wire 5 of the insulated electrical wire 4 can be used as a wire that penetrates through the center of the secondary coil. This can reduce influence of disturbing magnetic flux, such as noise, which is interlinked with the coil thin wire 7 as the secondary coil.

Then, as illustrated in FIG. 2C, the insulated electrical wire 4 and the coil thin wire 7 are covered with the heat shrinkable tube 9 to manufacture the current sensor 3 with a single-layer winding.

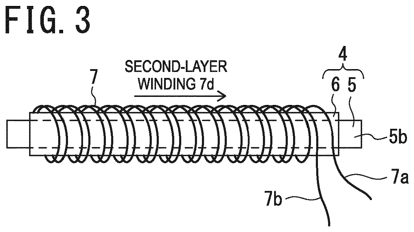

Here, FIG. 3 illustrates the current sensor 3 with a double-layer winding, in which a second-layer winding 7d is wound on the first-layer winding 7c on the outer periphery of the insulating covering portion 6 of the insulated electrical wire 4. Then, although not illustrated, the insulated electrical wire 4 and the first- and second-layer windings 7c and 7d are covered with the heat shrinkable tube 9 to manufacture the current sensor 3 with the double-layer winding.

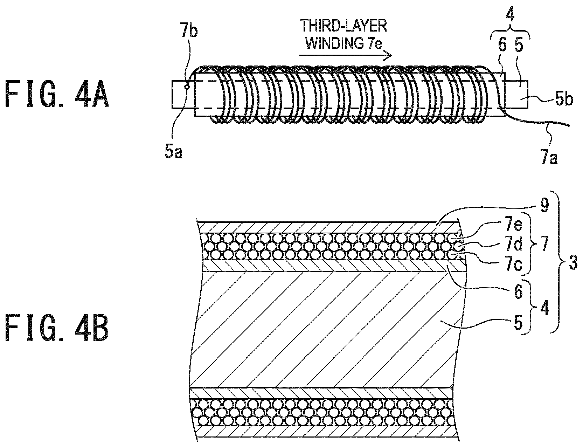

Additionally, FIGS. 4A and 4B illustrate the current sensor 3 with a triple-layer winding. As illustrated in FIG. 4A, a third-layer winding 7e is wound on the second-layer winding 7d on the outer periphery of the insulating covering portion 6 of the insulated electrical wire 4, and as illustrated in FIG. 4B, the insulated electrical wire 4 and the first- to third-layer windings 7c, 7d, and 7e are covered with the heat shrinkable tube 9 to manufacture the current sensor 3 with the triple-layer winding.

Next, operation of the current measurement device 1 of the first embodiment configured as above is described.

Around the measurement conductor 2a, which is a primary conductor where current (alternating current) flows, a magnetic field is generated by the current. Magnetic flux passing in an interlinked manner through an inside of the coil thin wire 7, which is the secondary coil of the spirally surrounding current sensor 3, generates an electromotive voltage (output voltage) on the coil thin wire 7. Then, the output voltage corresponding to the alternating current of the measurement conductor 2a is output from the output terminals 5b and 7a of the current sensor 3 to the output voltage RMS value measurement circuit 10. The output waveform of the current sensor 3 changes in response to the output voltage. The current value conversion arithmetic unit 11 calculates a current value with respect to input voltage RMS value by a relational expression between voltage RMS value of the current sensor 3 and measured current.

Next is a description of performance of the current sensor 3 forming the current measurement device 1 of the present embodiment and effects when manufacturing the current sensor 3.

The current sensor 3 of the present embodiment does not have to limit the amount of coil winding due to the limitation of the amount of wire storage, as is the case with Rogowski coils having an annular insulated core. Providing the multiple layers of the windings 7c to 7e on the insulating covering portion 6 on the outer periphery of the core wire 5 (see FIGS. 2C, 3, and 4B) can increase output voltage, enabling high-sensitivity measurement of alternating current flowing through the measurement conductor 2a.

Additionally, when manufacturing the current sensor 3, coil winding operation of the secondary coil is completed only by winding the coil thin wire 7 in a coil shape around the outer periphery of the rod-shaped core wire 5 covered with the insulating covering portion 6 from one end side toward the other end side or from the other end side toward the one end side. Thus, there is no need for a dedicated facility for winding a coil winding around an annular insulator core, as in the conventional Rogowski coils, enabling reduced manufacturing cost of the current sensor 3.

Here, in the current sensor 3 of the present embodiment, when thickness of the insulating covering portion 6 is increased, coil diameter of the coil thin wire 7 wound in the coil shape on the insulating covering portion 6 becomes large. This increases the amount of the magnetic flux passing through an inner periphery of the coil, enabling increased output voltage.

In addition, in the current sensor 3 of the present embodiment, increasing the length of the core wire 5 of the insulated electrical wire 4 increases the length of the winding portion, which thereby can increase the number of windings and the number of times of spiral winding, enabling increased output voltage. Thus, increasing the thickness of the insulating covering portion 6 or increasing the length of the insulated electrical wire 4 enables high-sensitivity measurement of alternating current flowing through the measurement conductor 2a.

Furthermore, as in the present embodiment, when measuring a low measured current flowing through the measurement conductor 2a, thinning the core wire 5 of the insulated electrical wire 4 to reduce the diameter of the spiral shape reduces the magnetic path length, enabling increased output voltage.

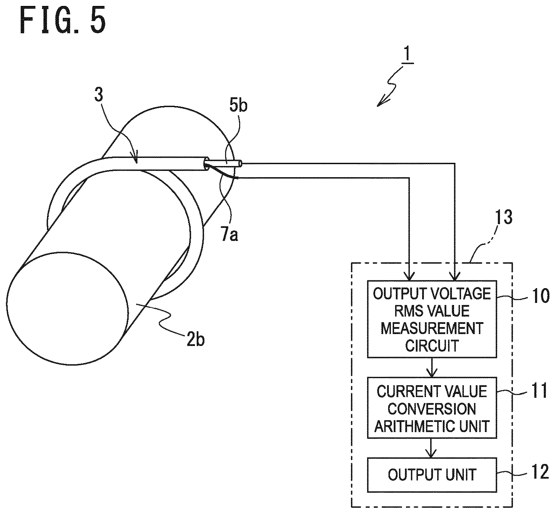

Here, FIG. 5 illustrates the current measurement device 1 of the first embodiment for measuring the measured current of a measurement conductor 2b where a large primary current flows. In this case, since the diameter of the measurement conductor 2b with large current flow is large, the core wire 5 of the insulated electrical wire 4 of the current sensor 3 may be set to have a length such that the number of times of spiral winding is 0.8 or 1.7.

### Second Embodiment

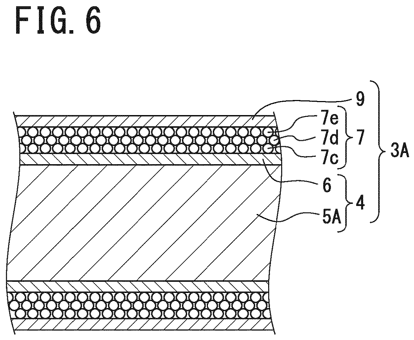

Next, FIG. 6 illustrates a current sensor 3A with a triple-layer winding of a second embodiment. Additionally, the same components as those of the current sensor 3 with the triple-layer winding of the first embodiment illustrated in FIG. 4B are denoted by the same reference signs, and descriptions thereof are omitted.

A core wire 5A forming the insulated electrical wire 4 of the current sensor 3A of the present embodiment is formed by a rod-shaped body made of a conductive material such as iron, permalloy, nickel alloy, or silicon steel, which is a soft magnetic material. Additionally, as with the current sensor 3 of the first embodiment, the insulating covering portion 6 forming the insulated electrical wire 4 is formed by using an insulating resin tube or by applying an insulating resin.

A method for manufacturing the current sensor 3A of the present embodiment is substantially the same as the method for manufacturing the current sensor 3 with the triple-layer winding of the first embodiment. A different point is that the core wire 5A is made of a soft magnetic material. Using an iron wire makes soldering difficult. It is therefore necessary to perform electrical bonding by welding or pass a copper wire in parallel with the iron wire to secure a penetration line.

Then, the current sensor 3A of the present embodiment is also mounted around the measurement conductor 2a by spirally deforming the core wire 5A of the insulated electrical wire 4 so as to surround the measurement conductor 2a.

According to the current sensor 3A of the present embodiment, the core wire 5A made of a soft magnetic material attracts magnetic flux, which generates a higher value of induced current than in the current sensor 3 of the first embodiment. Accordingly, since the current sensor 3A of the second embodiment can increase the output voltage compared to the current sensor 3 of the first embodiment, alternating current flowing through the measurement conductor 2a can be measured with high sensitivity.

### Third Embodiment

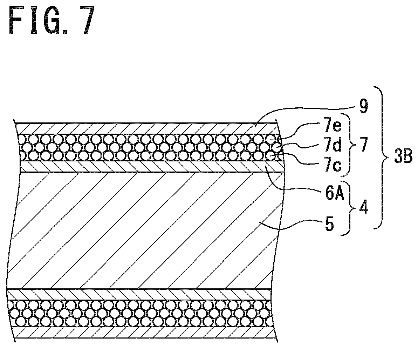

Next, FIG. 7 illustrates a current sensor 3B with a triple-layer winding of a third embodiment.

A method for manufacturing the current sensor 3B of the present embodiment is also substantially the same as the method for manufacturing the current sensor 3 with the triple-layer winding of the first embodiment. A different point is that soft magnetic powder is provided in a part of the insulating covering portion 6A forming the insulated electrical wire 4. A specific structure of the insulating covering portion 6A is a structure in which a part of the insulating covering portion made of an insulating resin is cut off and a soft magnetic sheet, for example, a rubber-like sheet mixed with soft magnetic powder is attached to the cut portion or a structure in which soft magnetic powder is kneaded into the insulating covering portion made of an insulating resin.

It should be noted that the soft magnetic powder forming the insulating covering portion 6A of the present embodiment includes any one of the following soft magnetic materials: compressed pure iron powder, ferrite powder, amorphous alloy powder, nanocrystalline magnetic powder, permalloy powder, sendust powder, iron cobalt powder, iron cobalt silicon powder, iron silicon vanadium alloy powder, iron cobalt boron alloy powder, and carbonyl iron powder, or any combination thereof.

Additionally, as with the current sensor 3 of the the first embodiment, the core wire 5 of the insulated electrical wire 4 of the current sensor 3B of the present embodiment is made of copper, which is a non-magnetic material, and the coil thin wire 7 is a copper wire.

Then, the current sensor 3B of the present embodiment is also mounted around the measurement conductor 2a by spirally winding the core wire 5 of the insulated electrical wire 4 so as to surround the measurement conductor 2a.

According to the current sensor 3B of the present embodiment, the insulating covering portion 6A mixed with soft magnetic powder attracts magnetic flux, which generates a higher value of induced current than in the current sensor 3 of the first embodiment. Accordingly, the current sensor 3B of present embodiment also can increase the output voltage compared to the current sensor 3 of the first embodiment, enabling high-sensitivity measurement of alternating current flowing through the measurement conductor 2a.

### Fourth Embodiment

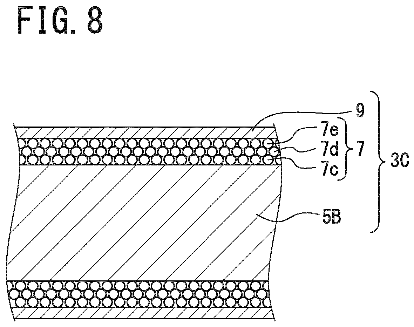

Next, FIG. 8 illustrates a current sensor 3C with a triple-layer winding of a fourth embodiment.

The current sensor 3C of the present embodiment uses a flexible aluminum electrical wire 5B, and an outer periphery of the aluminum electrical wire 5B is not provided with the insulating covering portions 6, 6A, and the like illustrated in the current sensors 3, 3A, and 3B with the triple-layer winding of the first to third embodiments.

In order to manufacture the current sensor 3C with a triple-layer winding of the present embodiment, the coil thin wire 7, which is a copper wire having an outer periphery provided with an insulating resin (insulating covering), is wound around an outer periphery of the aluminum electrical wire 5B put in a straight line as the first-layer winding 7c. Next, the second-layer winding 7d is wound on the first-layer winding 7c, and the third-layer winding 7e is wound on the second-layer winding 7d. Then, the first- to third-layer windings 7c, 7d, and 7e are covered with the heat shrinkable tube 9 to manufacture the current sensor 3C with the triple-layer winding.

Then, the current sensor 3C of the present embodiment is also mounted around the measurement conductor 2a in a state where the aluminum electrical wire 5B is spirally wound so as to surround the measurement conductor 2a.

Here, when the current sensors 3, 3A, and 3B with the triple-layer winding of the first to third embodiments are used in a high temperature environment (for example, an environment of about 100 to 120°C), the insulating covering portions 6 and 6A covering the outer peripheries of the core wires 5 and 5A in the insulated electrical wires 4 of the first to third embodiments expand and contract, as a result of which the output voltage becomes unstable as inner diameters of the current sensors 3, 3A, and 3B change. On the other hand, in the current sensor 3C of the present embodiment, there is no insulating covering portion on the outer periphery of the aluminum electrical wire 5B. Therefore, even in high-temperature environments, the inner diameter thereof does not change, so that a stable output voltage can be obtained. Accordingly, the current sensor 3C of the present embodiment enables high-sensitivity measurement of alternating current flowing through the measurement conductor 2a even in high-temperature environments.

### Fifth Embodiment

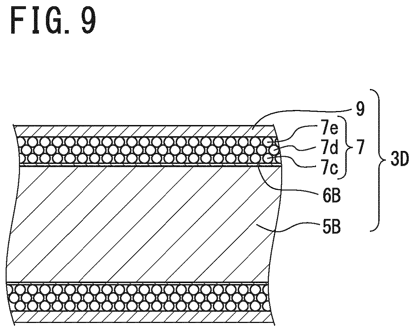

Next, FIG. 9 illustrates a current sensor 3D with a triple-layer winding of a fifth embodiment.

The current sensor 3D of the present embodiment is different from the current sensor 3C of the fourth embodiment in that the outer periphery of the flexible aluminum electrical wire 5B is provided with an anodized film 6B, which is an insulating oxide film.

A method for manufacturing the current sensor 3D of the present invention is also substantially the same as the method for manufacturing the current sensor 3C with the triple-layer winding of the fourth embodiment.

Additionally, the current sensor 3D of the present embodiment is also mounted around the measurement conductor 2a in the state where the aluminum electrical wire 5B is spirally wound so as to surround the measurement conductor 2a.

The current sensor 3D of the present embodiment is provided with the anodized film 6B, which can increase insulation between the aluminum electrical wire 5B and the first- to third-layer windings 7c, 7d, and 7e.

Accordingly, the current sensor 3D of the present embodiment enables higher-sensitivity measurement of alternating current flowing through the measurement conductor 2a.

### [Regarding Output Voltages of Current Sensors of First to Third Embodiments]

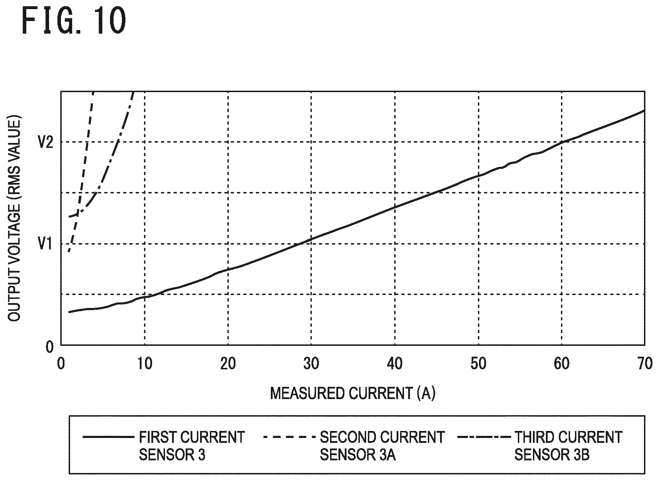

Next, the current sensor 3 with the triple-layer winding of the first embodiment is referred to as first current sensor 3, the current sensor 3A with the triple-layer winding of the second embodiment as second current sensor 3A, and the current sensor with the triple-layer winding of the third embodiment as third current sensor 3B. Then, output voltages of the first to third current sensors 3, 3A, and 3B are described with reference to FIGS. 10 to 13.

The first current sensor 3 used the core wire 5 made of copper (non-magnetic body) and having a diameter of 1.60 mm and the insulated electrical wire 4 in which the outer periphery of the core wire 5 was covered with the insulating covering portion 6 having a thickness of 0.8 mm, and the length of the core wire 5 was set to 80 mm.

Additionally, the second current sensor 3A used the core wire 5A made of iron wire (soft magnetic body) and having a diameter of 1.15 mm and the insulated electrical wire 4 in which the outer periphery of the core wire 5A was covered with the insulating covering portion 6 having a thickness of 1.025 mm, and the length of the core wire 5A was set to 80 mm.

Furthermore, the third current sensor 3B used the core wire 5 made of copper (non-magnetic body) and having a diameter of 1.60 mm and the insulated electrical wire 4 in which the insulating covering portion 6A having a thickness of 0.8 mm was cut off in a longitudinal direction with a width of 2 mm on the outer periphery of the core wire 5, and a soft magnetic sheet having a thickness of 0.5 mm was attached to the cut portion thereof with a width of 2 mm. The length of the core wire 5 of the insulated electrical wire 4 was set to 80 mm.

The diameters of the insulating covering portions 6 and 6A of the first to third current sensors 3, 3A, and 3B were made common. Then, the first to third current sensors 3, 3A, and 3B were spirally wound, each arranged around the measurement conductor 2a illustrated in FIG. 1, and connected to the output voltage RMS value measurement circuit 10 to measure the value of alternating current flowing through the measurement conductor 2a.

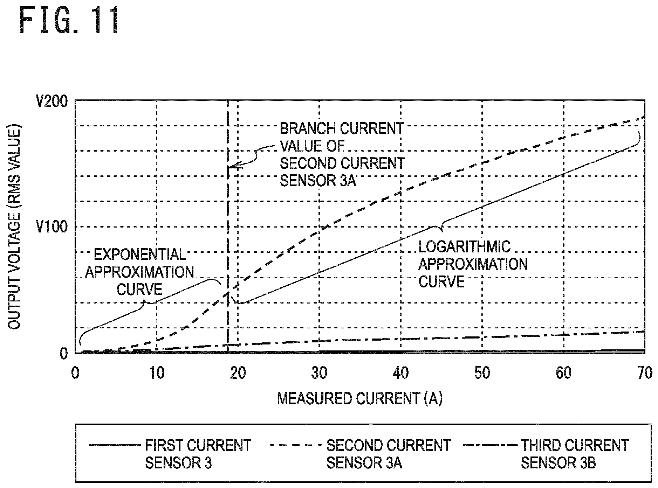

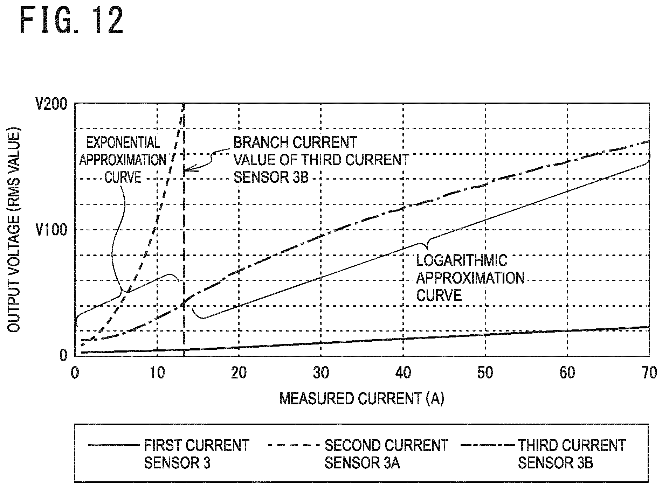

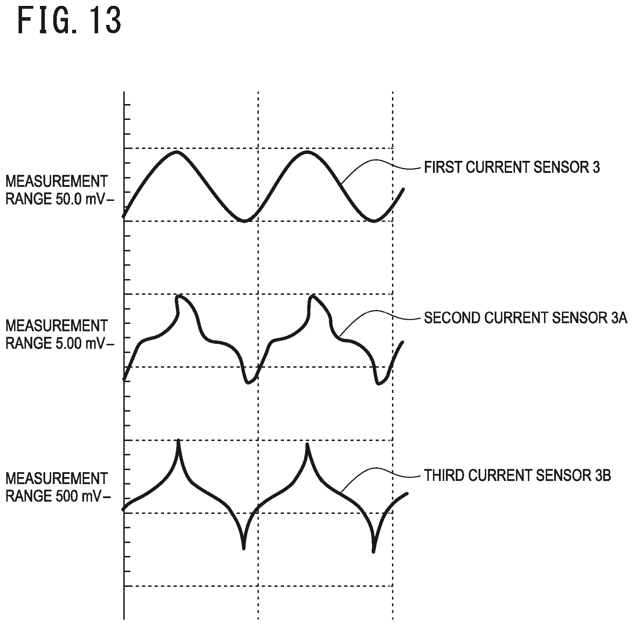

FIG. 10 is a graph comparing outputs of the first to third current sensors 3, 3A, and 3B by taking a current value (measured current) flowing through the measurement conductor 2a on the horizontal axis and taking the RMS value of an output voltage generated in response to change in the measured current on the vertical axis. Additionally, FIGS. 11 and 12 are graphs in which the scale of the output voltage on the vertical axis of FIG. 10 has been changed. Furthermore, FIG. 13 illustrates output waveforms of the first to third current sensors 3, 3A, and 3B when an alternating current of 50 A is flowing through the measurement conductor 2a.

The first current sensor 3 is characterized in that the output voltage is proportional to the measured current and a linear output can be obtained in a wide range of current measurement from low current measurement to high current measurement, as in FIGS. 10 to 12. Additionally, as in FIG. 13, the output is a sine wave, and therefore is not easily affected by a noise filter built into the output voltage RMS value measurement circuit 10. The arithmetic formula of the current value conversion arithmetic unit 11 can be expressed by a proportional formula, and the output voltage is linearly proportional.

The second current sensor 3A is characterized in that a much higher output voltage can be obtained than that in the first current sensor 3, as illustrated in FIG. 11. Since the iron wire of the core wire 5A of the second current sensor 3A is spirally wound, the magnetic path length is not closed, and magnetic saturation is slower than in common CTs using an annular magnetic core. Even with the thin iron wire, saturation point extends to about 19 A. The arithmetic formula of the current value conversion arithmetic unit 11 requires a calculation formula expressed on an exponential approximation curve for less than the iron wire saturation point of 19 A, and a calculation formula expressed on a logarithmic approximation curve for equal to or more the iron wire saturation point of 19 A.

The second current sensor 3A has output voltage characteristics having an exponential approximation curve and a logarithmic approximation curve bounded by the iron wire saturation point. However, the saturation point can be controlled by changing a cross-sectional area of the core wire 5A made of iron (soft magnetic body) or a spiral winding pitch with respect to the measurement conductor 2a. Here, as illustrated in FIG. 13, the second current sensor 3A outputs a differential wave voltage, which causes a measurement error when passing the voltage through the noise filter of the output voltage RMS value measurement circuit 10. It is therefore necessary to use measured current value and RMS value of the output voltage RMS value measurement circuit 10 as a simulated measurement in advance to set constants of the arithmetic formula of the current value conversion arithmetic unit 11.

The third current sensor 3B is characterized in that a higher output voltage can be obtained than in the first current sensor 3 as illustrated in figure 12. As with the second current sensor 3A, the output voltage of the third current sensor 3B has output voltage characteristics having an exponential approximation curve and a logarithmic approximation curve bounded by a saturation point of the soft magnetic powder. However, the curve of the characteristic changes bounded by the saturation point is gentle, and the constants of the arithmetic formula of the current value conversion arithmetic unit 11 are smaller than those in the second current sensor 3A and close to those in the arithmetic formula of the first current sensor 3. In addition, similarly to the second current sensor 3A, changing the amount of magnetic powder to be mixed, the cross-sectional area of the soft magnetic sheet, or the winding width of the core wire 5 of the insulated electrical wire can change the branch current value to adjust the output voltage.

Here, as illustrated in FIG. 13, the third current sensor 3B outputs a differential wave voltage, as in the second current sensor 3A. Due to that, a measurement error occurs when passing the voltage through the noise filter of the output voltage RMS value measurement circuit 10. It is therefore necessary to use measured current value and RMS value of the output voltage RMS value measurement circuit 10 as a simulated measurement in advance to set the constants of the arithmetic formula of the current value conversion arithmetic unit 11.

Additionally, the first current sensor 3 can reduce noise by using a shielded wire for the insulated electrical wire 4 and inputting one of the core wire of the shielded wire or the shielded wire to a GND line of the output voltage RMS value measurement circuit 10. The second current sensor 3A can use a shielded wire for the insulated electrical wire 4, and one of the core wire 5A or the shielded wire or both thereof can be made of a soft magnetic material. In addition, the second current sensor 3A can reduce noise by inputting one of the core wire of the shield or the shielded wire to the GND line of the output voltage RMS value measurement circuit 10. Furthermore, an insulated electrical wire including the core wire 5 made of a soft magnetic body can be combined with the third current sensor 3B.

### REFERENCE SIGNS LIST

1: Current measurement device
2a, 2b: Measurement conductor
3: Current sensor (First Embodiment, first current sensor)
3A: Current sensor (Second Embodiment, second current sensor)
3B: Current sensor (Third Embodiment, third current sensor)
3C: Current sensor (Fourth Embodiment, fourth current sensor)
3D: Current sensor (Fifth Embodiment, fifth current sensor)
4: Insulated electrical wire
5: Core wire (First and Third Embodiments)
5A: Core wire (Second Embodiment)
5B: Aluminum electrical wire (Fourth and Fifth Embodiments)
5a: Electrical connection portion
5b, 7a: Output terminal
6: Insulating covering portion (First and Second Embodiments)
6A: Insulating covering portion (Third Embodiment)
6B: Anodized film (Fifth Embodiment)
7: Coil thin wire
7b: Winding end portion
7c: First-layer winding
7d: Second-layer winding
7e: Third-layer winding
9: Heat shrinkable tube
10: Output voltage RMS value measurement circuit
11: Current value conversion arithmetic unit
12: Output unit
13: Measured current display device

## Claims

1. A current sensor (3, 3A, 3B, 3C, 3D) wound and mounted in a spiral shape with at least one winding around a measurement conductor (2a, 2b) where a primary current flows, the current sensor (3, 3A, 3B, 3C, 3D) comprising:
an insulated electrical wire (4) including a core wire (5, 5A) having a flexible rod-shaped body and an insulating covering portion (6, 6A) covering an outer periphery of the core wire (5, 5A); and
a coil thin wire (7) having one end electrically connected to one end side of the core wire (5, 5A), and functioning as a secondary coil by being wound around an outer periphery of the insulating covering portion (6, 6A);
wherein an other end of the core wire (5, 5A) and an other end of the coil thin wire (7), which are not electrically connected, are used as output terminals (5b, 7a);
**characterized in that**:
the coil thin wire (7) comprises a first-layer winding (7c) wound on the outer periphery of the insulating covering portion (6, 6A), a second-layer winding (7d) wound on the first-layer winding (7c), and a third-layer winding (7e) wound on the second-layer winding (7d).

2. The current sensor (3, 3A, 3B, 3C, 3D) according to claim 1, wherein the core wire (5, 5A) of the insulated electrical wire (4) is a soft magnetic wire.

3. The current sensor (3, 3A, 3B, 3C, 3D) according to claim 1, wherein a rubber-like sheet mixed with soft magnetic powder is attached to a part of the insulating covering portion (6, 6A) of the insulated electrical wire (4).

4. The current sensor (3, 3A, 3B, 3C, 3D) according to claim 1, wherein the insulating covering portion (6, 6A) of the insulated electrical wire (4) contains soft magnetic powder.

5. A current sensor wound and mounted in a spiral shape with at least one winding around a measurement conductor (2a, 2b) where a primary current flows, the current sensor (3, 3A, 3B, 3C, 3D) comprising:
a flexible aluminum electrical wire (5B); and
a coil thin wire (7) having an outer periphery provided with insulating covering, the coil thin wire (7) having one end electrically connected to one end side of the aluminum electrical wire (5B), and functioning as a secondary coil by being wound around an outer periphery of the aluminum electrical wire (5B);
wherein an other end of the aluminum electrical wire (5B) and an other end of the coil thin wire (7), which are not electrically connected, are used as output terminals (5b, 7a);
wherein an outer periphery of the aluminum electrical wire (5B) is provided with an anodized film (6B); and
wherein the coil thin wire (7) comprises a first-layer winding (7c) wound on the outer periphery of the insulating covering portion (6, 6A), a second-layer winding (7d) wound on the first-layer winding (7c), and a third-layer winding (7e) wound on the second-layer winding (7d).

6. A method for manufacturing a current sensor (3, 3A, 3B, 3C, 3D), which is a method for manufacturing the current sensor (3, 3A, 3B, 3C, 3D) according to any one of claims 1 to 4, the method comprising:
electrically connecting one end of the coil thin wire (7) to one end side of the core wire (5, 5A) of the insulated electrical wire (4);
winding the coil thin wire (7) around an outer periphery of the insulating covering portion (6, 6A) of the insulated electrical wire (4) from the one end side to arrange as a secondary coil;
using an other end of the core wire (5, 5A) and an other end of the coil thin wire (7), which are not electrically connected, as output terminals (5b, 7a); and
winding the insulated electrical wire wound with the coil thin wire (7) around a measurement conductor (2a, 2b) where a primary current flows, in a spiral shape with at least one winding.

7. A method for manufacturing a current sensor (3, 3A, 3B, 3C, 3D), which is a method for manufacturing the current sensor (3, 3A, 3B, 3C, 3D) according to claim 5, the method comprising:
electrically connecting one end of the coil thin wire (7) to one end side of the aluminum electrical wire (5B), an anodized film (6B) being provided on an outer periphery of the aluminum electrical wire (5B);
winding the coil thin wire (7) around the anodized film (6B) on an outer periphery of the aluminum electrical wire (5B) from the one end side to arrange as a secondary coil; and
using an other end of the aluminum electrical wire (5B) and an other end of the coil thin wire (7), which are not electrically connected, as output terminals (5b, 7a); and
winding the aluminum electrical wire (5B) wound with the coil thin wire (7) around a measurement conductor (2a, 2b) where a primary current flows, in a spiral shape with at least one winding.

## Patentansprüche

1. Stromsensor (3, 3A, 3B, 3C, 3D), der in einer Spiralform mit mindestens einer Windung um einen Messleiter (2a, 2b) gewickelt und angebracht ist, in dem ein Primärstrom fließt, wobei der Stromsensor (3, 3A, 3B, 3C, 3D) umfasst:
einen isolierten elektrischen Draht (4) einschließlich eines Kerndrahts (5, 5A), der einen flexiblen, stabförmigen Körper aufweist, und eines isolierenden Abdeckungsabschnitts (6, 6A), der einen Außenumfang des Kerndrahts (5, 5A) abdeckt; und
einen dünnen Spulendraht (7), dessen eines Ende mit einer Endseite des Kerndrahts (5, 5A) elektrisch verbunden ist und der als Sekundärspule fungiert, indem er um einen Außenumfang des isolierenden Abdeckungsabschnitts (6, 6A) gewickelt ist;
wobei ein anderes Ende des Kerndrahts (5, 5A) und ein anderes Ende des dünnen Spulendrahts (7), die nicht elektrisch verbunden sind, als Ausgangsanschlüsse (5b, 7a) verwendet werden;
**dadurch gekennzeichnet, dass**:
der dünne Spulendraht (7) eine auf den Außenumfang des isolierenden Abdeckungsabschnitts (6, 6A) gewickelte erste Wicklungsschicht (7c), eine auf die erste Wicklungsschicht (7c) gewickelte zweite Wicklungsschicht (7d) und eine auf die zweite Wicklungsschicht (7d) gewickelte dritte Wicklungsschicht (7e) umfasst.

2. Stromsensor (3, 3A, 3B, 3C, 3D) nach Anspruch 1, wobei der Kerndraht (5, 5A) des isolierten elektrischen Drahts (4) ein weichmagnetischer Draht ist.

3. Stromsensor (3, 3A, 3B, 3C, 3D) nach Anspruch 1, wobei eine mit weichmagnetischem Pulver vermischte gummiartige Folie an einem Teil des isolierenden Abdeckungsabschnitts (6, 6A) des isolierten elektrischen Drahts (4) angebracht ist.

4. Stromsensor (3, 3A, 3B, 3C, 3D) nach Anspruch 1, wobei der isolierende Abdeckungsabschnitt (6, 6A) des isolierten elektrischen Drahts (4) weichmagnetisches Pulver enthält.

5. Stromsensor, der in einer Spiralform mit mindestens einer Windung um einen Messleiter (2a, 2b) gewickelt und angebracht ist, in dem ein Primärstrom fließt, wobei der Stromsensor (3, 3A, 3B, 3C, 3D) umfasst:
einen flexiblen Aluminiumelektrodraht (5B); und
einen dünnen Spulendraht (7), dessen Außenumfang mit einer isolierenden Abdeckung versehen ist, wobei der dünne Spulendraht (7) mit einem Ende mit einer Endseite des Aluminiumelektrodrahts (5B) elektrisch verbunden ist und als Sekundärspule fungiert, indem er um einen Außenumfang des Aluminiumelektrodrahts (5B) gewickelt ist;
wobei ein anderes Ende des Aluminiumelektrodrahts (5B) und ein anderes Ende des dünnen Spulendrahts (7), die nicht elektrisch verbunden sind, als Ausgangsanschlüsse (5b, 7a) verwendet werden;
wobei ein Außenumfang des Aluminiumelektrodrahts (5B) mit einer eloxierten Schicht (6B) versehen ist; und
wobei der dünne Spulendraht (7) eine auf den Außenumfang des isolierenden Abdeckungsabschnitts (6, 6A) gewickelte erste Wicklungsschicht (7c), eine auf die erste Wicklungsschicht (7c) gewickelte zweite Wicklungsschicht (7d) und eine auf die zweite Wicklungsschicht (7d) gewickelte dritte Wicklungsschicht (7e) umfasst.

6. Verfahren zur Herstellung eines Stromsensors (3, 3A, 3B, 3C, 3D), das ein Verfahren zur Herstellung des Stromsensors (3, 3A, 3B, 3C, 3D) nach einem der Ansprüche 1 bis 4 ist, wobei das Verfahren umfasst:
elektrisch Verbinden eines Endes des dünnen Spulendrahts (7) mit einer Endseite des Kerndrahts (5, 5A) des isolierten elektrischen Drahts (4);
Wickeln des dünnen Spulendrahts (7) um einen Außenumfang des isolierenden Abdeckungsabschnitts (6, 6A) des isolierten elektrischen Drahts (4) von der einen Endseite, um ihn als Sekundärspule anzuordnen;
Verwenden eines anderen Endes des Kerndrahts (5, 5A) und eines anderen Endes des dünnen Spulendrahts (7), die nicht elektrisch verbunden sind, als Ausgangsanschlüsse (5b, 7a); und
Wickeln des mit dem dünnen Spulendraht (7) umwickelten isolierten elektrischen Drahts in einer Spiralform mit mindestens einer Windung um einen Messleiter (2a, 2b), in dem ein Primärstrom fließt.

7. Verfahren zur Herstellung eines Stromsensors (3, 3A, 3B, 3C, 3D), das ein Verfahren zur Herstellung des Stromsensors (3, 3A, 3B, 3C, 3D) nach Anspruch 5 ist, wobei das Verfahren umfasst:
elektrisch Verbinden eines Endes des dünnen Spulendrahts (7) mit einer Endseite des Aluminiumelektrodrahts (5B), wobei eine eloxierte Schicht (6B) an einem Außenumfang des Aluminiumelektrodrahts (5B) vorgesehen ist;
Wickeln des dünnen Spulendrahts (7) um die eloxierte Schicht (6B) an einem Außenumfang des Aluminiumelektrodrahts (5B) von der einen Endseite, um ihn als Sekundärspule anzuordnen; und
Verwenden eines anderen Endes des Aluminiumelektrodrahts (5B) und eines anderen Endes des dünnen Spulendrahts (7), die nicht elektrisch verbunden sind, als Ausgangsanschlüsse (5b, 7a); und
Wickeln des mit dem dünnen Spulendraht (7) umwickelten Aluminiumelektrodrahts (5B) in einer Spiralform mit mindestens einer Windung um einen Messleiter (2a, 2b), in dem ein Primärstrom fließt.

## Revendications

1. Capteur de courant (3, 3A, 3B, 3C, 3D) qui est enroulé et monté en forme de spirale avec au moins un enroulement autour d'un conducteur de mesure (2a, 2b) dans lequel un courant primaire circule, le capteur de courant (3, 3A, 3B, 3C, 3D) comprenant :
un fil électrique isolé (4) comprenant un fil central (5, 5A) ayant un corps flexible en forme de tige et une partie de revêtement isolant (6, 6A) recouvrant une périphérie extérieure du fil central (5, 5A) ; et
un fil fin de bobine (7) ayant une extrémité en connexion électrique avec un côté d'extrémité du fil central (5, 5A), et fonctionnant comme une bobine secondaire par enroulement autour d'une périphérie extérieure de la partie de revêtement isolant (6, 6A) ;
dans lequel une autre extrémité du fil central (5, 5A) et une autre extrémité du fil fin de bobine (7), qui ne sont pas en connexion électrique, sont utilisées comme bornes de sortie (5b, 7a) ;
**caractérisé en ce que** :
le fil fin de bobine (7) comprend un enroulement de première couche (7c) enroulé sur la périphérie extérieure de la partie de revêtement isolant (6, 6A), un enroulement de deuxième couche (7d) enroulé sur l'enroulement de première couche (7c), et un enroulement de troisième couche (7e) enroulé sur l'enroulement de deuxième couche (7d).

2. Capteur de courant (3, 3A, 3B, 3C, 3D) selon la revendication 1, dans lequel le fil central (5, 5A) du fil électrique isolé (4) est un fil magnétique doux.

3. Capteur de courant (3, 3A, 3B, 3C, 3D) selon la revendication 1, dans lequel une feuille de type caoutchouc mélangée avec de la poudre magnétique douce est fixée sur une partie de la partie de revêtement isolant (6, 6A) du fil électrique isolé (4).

4. Capteur de courant (3, 3A, 3B, 3C, 3D) selon la revendication 1, dans lequel la partie de revêtement isolant (6, 6A) du fil électrique isolé (4) contient de la poudre magnétique douce.

5. Capteur de courant enroulé et monté en forme de spirale avec au moins un enroulement autour d'un conducteur de mesure (2a, 2b) dans lequel un courant primaire circule, le capteur de courant (3, 3A, 3B, 3C, 3D) comprenant :
un fil électrique en aluminium flexible (5B) ; et
un fil fin de bobine (7) ayant une périphérie extérieure pourvue d'un revêtement isolant, le fil fin de bobine (7) ayant une extrémité en connexion électrique avec un côté d'extrémité du fil électrique en aluminium flexible (5B), et fonctionnant comme une bobine secondaire par enroulement autour d'une périphérie extérieure du fil électrique en aluminium flexible (5B) ;
dans lequel une autre extrémité du fil électrique en aluminium flexible (5B) et une autre extrémité du fil fin de bobine (7), qui ne sont pas en connexion électrique, sont utilisées comme bornes de sortie (5b, 7a) ;
dans lequel une périphérie extérieure du fil électrique en aluminium flexible (5B) est pourvue d'un film anodisé (6B) ; et
dans lequel le fil fin de bobine (7) comprend un enroulement de première couche (7c) enroulé sur la périphérie extérieure de la partie de revêtement isolant (6, 6A), un enroulement de deuxième couche (7d) enroulé sur l'enroulement de première couche (7c), et un enroulement de troisième couche (7e) enroulé sur l'enroulement de deuxième couche (7d).

6. Procédé de fabrication d'un capteur de courant (3, 3A, 3B, 3C, 3D), qui est un procédé de fabrication du capteur de courant (3, 3A, 3B, 3C, 3D) selon l'une quelconque des revendications 1 à 4, le procédé comprenant :
connexion électrique d'une extrémité du fil fin de bobine (7) à un côté d'extrémité du fil central (5, 5A) du fil électrique isolé (4) ;
enroulement du fil fin de bobine (7) autour d'une périphérie extérieure de la partie de revêtement isolant (6, 6A) du fil électrique isolé (4) à partir du côté d'extrémité pour disposer comme une bobine secondaire ;
utilisation d'une autre extrémité du fil central (5, 5A) et d'une autre extrémité du fil fin de bobine (7), qui ne sont pas en connexion électrique, comme bornes de sortie (5b, 7a) ; et
enroulement du fil électrique isolé enroulé avec le fil fin de bobine (7) autour d'un conducteur de mesure (2a, 2b) dans lequel un courant primaire circule, en forme de spirale avec au moins un enroulement.

7. Procédé de fabrication d'un capteur de courant (3, 3A, 3B, 3C, 3D), qui est un procédé de fabrication du capteur de courant (3, 3A, 3B, 3C, 3D) selon la revendication 5, le procédé comprenant :
connexion électrique d'une extrémité du fil fin de bobine (7) à un côté d'extrémité du fil électrique en aluminium flexible (5B), un film anodisé (6B) étant pourvu sur une périphérie extérieure du fil électrique en aluminium flexible (5B) ;
enroulement du fil fin de bobine (7) autour du film anodisé (6B) sur une périphérie extérieure du fil électrique en aluminium flexible (5B) à partir du côté d'extrémité pour disposer comme une bobine secondaire ; et
utilisation d'une autre extrémité du fil électrique en aluminium flexible (5B) et d'une autre extrémité du fil fin de bobine (7), qui ne sont pas en connexion électrique, comme bornes de sortie (5b, 7a) ; et
enroulement du fil électrique en aluminium flexible (5B) enroulé avec le fil fin de bobine (7) autour d'un conducteur de mesure (2a, 2b) dans lequel un courant primaire circule, en forme de spirale avec au moins un enroulement.
